# EUROPEAN PATENT APPLICATION

(11) **EP 4 660 782 A1**
(43) Date of publication of application: **10.12.2025**
(21) Application number: 24766299.2
(22) Date of filing: 28.02.2024
(51) Int. Cl.: G06F 7/483

(54) **FLOATING-POINT DATA PRECISION CONVERSION METHOD AND APPARATUS**

(30) Priority: 03.03.2023 CN 202310238789
(71) Applicant: Huawei Technologies Co., Ltd., Shenzhen, Guangdong 518129 (CN)
(72) Inventor: WU, Wei Hsiang, Shenzhen, Guangdong 518129 (CN); LUO, Yuanyong, Shenzhen, Guangdong 518129 (CN); CHEN, Minqi, Shenzhen, Guangdong 518129 (CN); ZHANG, Zhongxing, Shenzhen, Guangdong 518129 (CN)
(74) Representative: MERH-IP Matias Erny Reichl Hoffmann Patentanwälte PartG mbB
(86) International application number: PCT/CN2024/078993
(87) International publication number: WO 2024/183577

(57) **Abstract**

Embodiments of this application relate to the field of chip technologies, and provide a floating-point data precision conversion method and apparatus, reducing a conversion error during conversion from high-precision data into low-precision data. A specific solution is: determining a bit width of a second mantissa field based on a coded value of a first exponent field; determining a reserved coded value and a discarded coded value in a first mantissa field, where the reserved coded value includes a coded value that starts from a most significant bit in the first mantissa field and whose bit width is the same as the bit width of the second mantissa field; and if the coded value of the first exponent field is greater than or equal to a first preset threshold, performing a rounding operation on the reserved coded value based on a coded value that starts from a most significant bit and whose bit width is a preset bit width in the discarded coded value, to obtain a coded value of the second mantissa field; or if the coded value of the first exponent field is less than the first preset threshold, performing a rounding operation on the reserved coded value based on the most significant bit of the discarded coded value, to obtain the coded value of the second mantissa field. Embodiments of this application are applied to a process of floating-point data precision conversion.

## Description

This application claims priority to Chinese Patent Application No. 202310238789.3, filed with the China National Intellectual Property Administration on March 3, 2023 and entitled "FLOATING-POINT DATA PRECISION CONVERSION METHOD AND APPARATUS", which is incorporated herein by reference in its entirety.

### TECHNICAL FIELD

Embodiments of this application relate to the field of chip technologies, and in particular, to a floating-point data precision conversion method and apparatus.

### BACKGROUND

With development of the artificial intelligence (artificial intelligence, AI) field, a neural network (neural network, NN) keeps increasing in scale, and requirements for computing power for training the neural network are also increasing. Currently, a sharp growth in model training computing power causes high overheads in chip costs. Using existing floating-point (floating-point, FP) 16 mixed precision data and brain floating-point (brain floating-point, BF) 16 precision data have excessively high costs. However, using low-bit data for computation can implement lossless training for a large model of a transformer (transformer). Therefore, low-bit floating-point training is a future trend for large model training.

However, in a neural network training process, a mixed-precision computing scenario involves mutual conversion between floating-point data of different precision. Format conversion from low-precision floating-point data to high-precision floating-point data is error-free conversion, while format conversion from high-precision floating-point data into low-precision floating-point data involves a rounding (round) operation performed on the high-precision floating-point data. As a result, a conversion error is caused thereof, affecting training precision of model training.

### SUMMARY

Embodiments of this application provide a floating-point data precision conversion method and apparatus, reducing a conversion error of converting high-precision floating-point data into low-precision floating-point data.

To achieve the foregoing objective, the following technical solutions are applied in embodiments of this application.

According to a first aspect, an embodiment of this application provides a floating-point data precision conversion method. First floating-point data includes a first exponent field and a first mantissa field. Second floating-point data includes a second mantissa field. Precision of the first floating-point data is higher than precision of the second floating-point data. The method includes: determining a bit width of the second mantissa field based on a coded value of the first exponent field; determining a reserved coded value and a discarded coded value in the first mantissa field, where the reserved coded value includes a coded value that starts from a most significant bit in the first mantissa field and whose bit width is the same as the bit width of the second mantissa field; and if the coded value of the first exponent field is greater than or equal to a first preset threshold, performing a rounding operation on the reserved coded value based on a coded value that starts from a most significant bit and whose bit width is a preset bit width in the discarded coded value, to obtain a coded value of the second mantissa field; or if the coded value of the first exponent field is less than the first preset threshold, performing a rounding operation on the reserved coded value based on the most significant bit of the discarded coded value, to obtain the coded value of the second mantissa field.

Therefore, according to the floating-point data precision conversion method provided in this embodiment of this application, high-precision floating-point data is converted into low-precision floating-point data. The performing the rounding operation on the reserved coded value based on the coded value that starts from the most significant bit and whose bit width is the preset bit width in the discarded coded value may be understood as a stochastic rounding manner, and the performing a rounding operation on the reserved coded value based on the most significant bit of the discarded coded value may be understood as a manner of rounding half away from zero. In data format conversion, selection between the stochastic rounding manner and the manner of rounding half away from zero can be understood as a hybrid rounding manner. When the coded value of the first exponent field is greater than or equal to the first preset threshold, the stochastic rounding manner is used. When the coded value of the first exponent field is less than the first preset threshold, the manner of rounding half away from zero is used. Therefore, different rounding manners are provided, so that a conversion error during data format conversion can be reduced, data conversion efficiency can be improved, and training precision of model training can be improved.

In a possible design, the rounding operation includes a carrying operation and a discarding operation, and the performing the rounding operation on the reserved coded value based on the coded value that starts from the most significant bit and whose bit width is the preset bit width in the discarded coded value, to obtain the coded value of the second mantissa field includes: when the coded value that starts from the most significant bit and whose bit width is the preset bit width in the discarded coded value is greater than or equal to a second preset threshold, performing a carrying operation on a least significant bit of the reserved coded value, and performing a discarding operation on the discarded coded value, where a coded value obtained through carrying of the reserved coded value is the coded value of the second mantissa field; or when the coded value that starts from the most significant bit and whose bit width is the preset bit width in the discarded coded value is less than the second preset threshold, performing a discarding operation on the discarded coded value, where the reserved coded value is the coded value of the second mantissa field. The second preset threshold is a coded value that starts from a least significant bit and whose bit width is the preset bit width in the discarded coded value.

In this design, in the stochastic rounding manner, the second preset threshold for comparison is a coded value that starts from the least significant bit and whose bit width is the preset bit width in the discarded coded value. The second preset threshold is generated without an additional random number generator, and there is no performance bottleneck of random number generation, so that efficiency of converting high-precision floating-point data into low-precision floating-point data is improved, and hardware overheads are lower.

In a possible design, the rounding operation includes a carrying operation and a discarding operation, and the performing the rounding operation on the reserved coded value based on the most significant bit of the discarded coded value, to obtain the coded value of the second mantissa field includes: when the most significant bit of the discarded coded value is greater than or equal to a third preset threshold, performing a carrying operation on a least significant bit of the reserved coded value, and performing a discarding operation on the discarded coded value, where a coded value obtained through carrying of the reserved coded value is the coded value of the second mantissa field; or when the most significant bit of the discarded coded value is less than the third preset threshold, performing a discarding operation on the discarded coded value, where the reserved coded value is the coded value of the second mantissa field.

In this design, the third preset threshold may be 0 or 1, and the most significant bit of the discarded coded value is compared with the third preset threshold. This belongs to the manner of rounding half away from zero. In addition to the manner of rounding half away from zero, a rounding manner away from an even number, a rounding manner away from an odd number, and the like may be further included. However, in comparison with other rounding manners, in the manner of rounding half away from zero, a hardware implementation area is smaller, power consumption overheads are less, and a data resolution is higher.

In a possible design, the first preset threshold is determined by traversing a plurality of pieces of first floating-point data.

In this design, the first preset threshold is an adjustable parameter, and accuracy of data format conversion can be improved by setting a proper value of the first preset threshold.

In a possible design, the first floating-point data further includes a sign field, and the second floating-point data further includes the sign field, a prefix code field, and a second exponent field. The prefix code field indicates a bit width of the second exponent field, and before the determining the bit width of the second mantissa field based on the coded value of the first exponent field, the method further includes: determining a bit width of the prefix code field, a coded value of the prefix code field, a bit width of the second exponent field, and a coded value of the second exponent field based on the coded value of the first exponent field.

In this design, during data format conversion, the sign field of the second floating-point data may be obtained based on the sign field of the first floating-point data, the prefix code field and the second exponent field of the second floating-point data may be obtained based on the first exponent field of the first floating-point data, and the second mantissa field of the second floating-point data may be obtained based on the first mantissa field of the first floating-point data. In the second floating-point data, the bit width of the second exponent field is indicated by a short prefix code field, so that precision or a bit width of a mantissa field of the second floating-point data can be effectively improved. In addition, the second floating-point data that provides precision of only one-bit mantissa can represent a large value range, effectively balancing a relationship among a bit width, a range, and precision of the second floating-point data. In addition, for the prefix code field, a prefix code coding scheme may be used, which occupies a small bit width, and is convenient to parse the second exponent field and the second mantissa field.

According to a second aspect, an embodiment of this application provides a floating-point data precision conversion apparatus. First floating-point data includes a first exponent field and a first mantissa field. Second floating-point data includes a second mantissa field. Precision of the first floating-point data is higher than precision of the second floating-point data. The apparatus includes: a bit width computation unit, configured to determine a bit width of the second mantissa field based on a coded value of the first exponent field; a mantissa field computation unit, configured to determine a reserved coded value and a discarded coded value in the first mantissa field, where the reserved coded value includes a coded value that starts from a most significant bit in the first mantissa field and whose bit width is the same as the bit width of the second mantissa field; and a rounding operation unit, configured to: if the coded value of the first exponent field is greater than or equal to a first preset threshold, perform a rounding operation on the reserved coded value based on a coded value that starts from a most significant bit and whose bit width is a preset bit width in the discarded coded value, to obtain a coded value of the second mantissa field, where the rounding operation unit is further configured to: if the coded value of the first exponent field is less than the first preset threshold, perform a rounding operation on the reserved coded value based on the most significant bit of the discarded coded value, to obtain the coded value of the second mantissa field.

For beneficial effects of the second aspect, refer to the descriptions of the first aspect.

In a possible design, the rounding operation includes a carrying operation and a discarding operation. The rounding operation unit is further configured to: when the coded value that starts from the most significant bit and whose bit width is the preset bit width in the discarded coded value is greater than or equal to a second preset threshold, perform a carrying operation on a least significant bit of the reserved coded value, and perform a discarding operation on the discarded coded value, where a coded value obtained through carrying of the reserved coded value is the coded value of the second mantissa field; or when the coded value that starts from the most significant bit and whose bit width is the preset bit width in the discarded coded value is less than the second preset threshold, perform a discarding operation on the discarded coded value, where the reserved coded value is the coded value of the second mantissa field. The second preset threshold is a coded value that starts from a least significant bit and whose bit width is the preset bit width in the discarded coded value.

In a possible design, the rounding operation includes a carrying operation and a discarding operation, and the rounding operation unit is further configured to: when the most significant bit of the discarded coded value is greater than or equal to a third preset threshold, perform a carrying operation on a least significant bit of the reserved coded value, and perform a discarding operation on the discarded coded value, where a coded value obtained through carrying of the reserved coded value is the coded value of the second mantissa field; or when the most significant bit of the discarded coded value is less than the third preset threshold, perform a discarding operation on the discarded coded value, where the reserved coded value is the coded value of the second mantissa field.

In a possible design, the first preset threshold is determined by traversing a plurality of pieces of first floating-point data.

In a possible design, the first floating-point data further includes a sign field, and the second floating-point data further includes the sign field, a prefix code field, and a second exponent field. The prefix code field indicates a bit width of the second exponent field, and the bit width computation unit is further configured to determine a bit width of the prefix code field, a coded value of the prefix code field, a bit width of the second exponent field, and a coded value of the second exponent field based on a coded value of the first exponent field.

According to a third aspect, an embodiment of this application provides a floating-point data precision conversion apparatus, including a processor and a memory. The memory stores computer instructions, and after executing the computer instructions, the processor performs the floating-point data precision conversion method in any one of the foregoing aspects and the possible implementations.

According to a fourth aspect, an embodiment of this application provides a computer-readable storage medium, including computer instructions. When the computer instructions are run on an electronic device, the electronic device is enabled to perform the floating-point data precision conversion method according to any one of the foregoing aspects and the possible implementations.

According to a fifth aspect, an embodiment of this application provides a computer program product. When the computer program product is run on a computer or a processor, the computer or the processor is enabled to perform the floating-point data precision conversion method according to any one of the foregoing aspects and the possible implementations.

According to a sixth aspect, an embodiment of this application provides a system. The system may include a wireless access device and at least one electronic device in any possible implementation of any one of the foregoing aspects. The electronic device and the wireless access device may perform the floating-point data precision conversion method in any one of the foregoing aspects and the possible implementations.

It may be understood that any floating-point data precision conversion apparatus, computer-readable storage medium, computer program product, or the like provided above may be used for the corresponding method provided above. Therefore, for beneficial effects that can be achieved by the floating-point data precision conversion apparatus, the computer-readable storage medium, or the computer program product, refer to the beneficial effects in the corresponding method. Details are not described herein again.

These aspects or other aspects in this application are more concise and comprehensible in the following descriptions.

### BRIEF DESCRIPTION OF DRAWINGS

FIG. 1 is a diagram of a data structure according to an embodiment of this application;
FIG. 2 is a diagram of distribution of exponent field-mantissa field bit width according to an embodiment of this application;
FIG. 3 is a diagram of a system or a device in which a floating-point data precision conversion apparatus is used according to an embodiment of this application;
FIG. 4 is a diagram of a structure of a SoC according to an embodiment of this application;
FIG. 5 is a flowchart of a floating-point data precision conversion method according to an embodiment of this application;
FIG. 6 is a diagram of a mantissa field of FP32 data converted into HiFloat8 data in an SR rounding manner according to an embodiment of this application;
FIG. 7 is a diagram of a mantissa field of FP16 data converted into HiFloat8 data in an SR rounding manner according to an embodiment of this application;
FIG. 8 is a diagram of distribution of a hybrid rounding manner according to an embodiment of this application;
FIG. 9 is a flowchart of neural network training according to an embodiment of this application;
FIG. 10 is another flowchart of neural network training according to an embodiment of this application;
FIG. 11 is another flowchart of neural network training according to an embodiment of this application; and
FIG. 12 is a diagram of composition of a floating-point data precision conversion apparatus according to an embodiment of this application.

### DESCRIPTION OF EMBODIMENTS

For ease of understanding, some concepts related to embodiments of this application are described for reference by using examples. Details are as follows.

A neural network training process mainly includes forward (forward) computation, backward (backward) computation, and weight (weight) update. A computation mode in the training process includes general matrix multiplication (general matrix multiplication, GEMM) and non-general matrix multiplication. A layer corresponding to general matrix multiplication computation may be referred to as a matrix multiplication computation layer, and a layer corresponding to non-general matrix multiplication computation may be referred to as a non-matrix multiplication computation layer. Specifically, the general matrix multiplication includes convolution (convolution), transposed convolution (transposed convolution), matrix multiplication (matmul), and batch matrix multiplication (batch matmul). The non-general matrix multiplication includes an activation function, a normalization function, optimizer gradient update computation, and the like. The activation function includes sigmoid, tanh, and relu. The normalization function includes batch normalization (batch normalization), layer normalization (layer normalization), instance normalization (instance normalization), and the like.

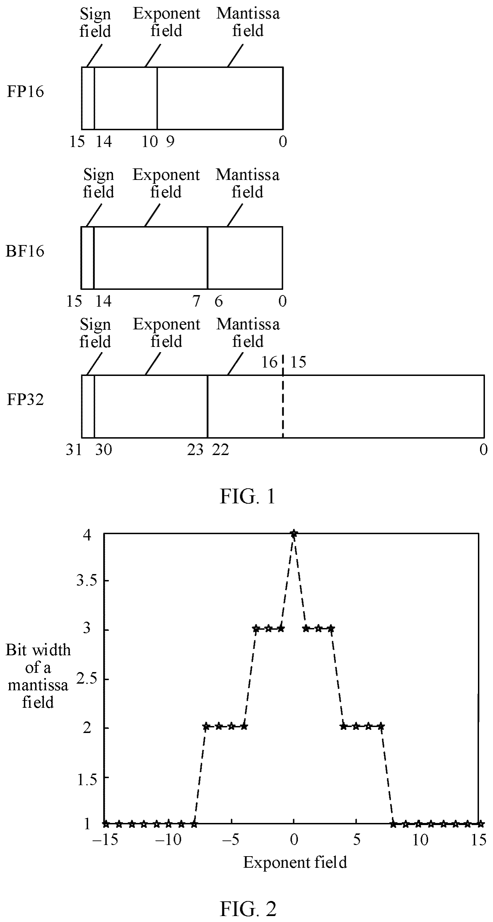

The general matrix multiplication may be performed by using FP16, BF16, or data of lower precision, and the non-general matrix multiplication needs to be performed by using data of higher precision such as FP32. The FP16 may also be referred to as a half-precision floating-point (half-precision floating-point), the BF16 may also be referred to as a 16-bit brain floating-point (brain floating-point), and the FP32 may also be referred to as a full precise floating-point (full-precise float). FIG. 1 is a diagram of a data structure. Specifically, the FP16 includes 16 bits, where one bit at a most significant bit is a sign field, intermediate five bits are an exponent field, and the remaining 10 bits are a mantissa field. The mantissa field represents a decimal. The BF16 includes 16 bits, where one bit at a most significant bit is a sign field, intermediate 8 bits are an exponent field, and the remaining 7 bits are a mantissa field. The FP32 includes 32 bits, where one bit at a most significant bit is a sign field, intermediate 8 bits are an exponent field, and the remaining 23 bits are a mantissa field.

The following describes the technical solutions in embodiments of this application with reference to the accompanying drawings in embodiments of this application. In descriptions in embodiments of this application, "/" means "or" unless otherwise specified. For example, A/B may represent A or B. In this specification, "and/or" describes only an association relationship for describing associated objects and represents that three relationships may exist. For example, A and/or B may represent the following three cases: Only A exists, both A and B exist, and only B exists. In addition, in the descriptions in embodiments of this application, "a plurality of" means two or more.

The terms "first" and "second" mentioned below are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of embodiments, unless otherwise specified, "a plurality of" means two or more.

Currently, neural network training has an increasing requirement for computing power. Specifically, a neural network training process requires 100 petaflops (where one petaflop equals 10 trillion mathematical operations per second) initially. In a current transformer model, a neural network training process requires 1 billion petaflops. The requirement for computing power has increased by 10 million times. Therefore, to reduce power consumption during neural network training, two low-precision floating-point data formats are defined in conventional technologies: FP8 (E5M2) and FP8 (E4M3). An FP8 (E5M2) exponent (exponent) field has five bits, and an FP8 (E5M2) mantissa (mantissa) field has 2 bits. An FP8 (E4M3) exponent field has 4 bits, and an FP8 (E4M3) mantissa field has 3 bits. In a training process of a neural network involving forward computation, backward computation, and weight update, mixed precision is used for training, where two FP8 data formats are used for computation in GEMM, and FP32 or FP16 is used for computation in non-GEMM. It may be understood that, in comparison between the general matrix multiplication computation performed by using data in the foregoing two low-precision floating-point data formats and the general matrix multiplication computation by using FP16/BF16 data, because a total bit width of the two low-precision floating-point data formats is half of a total bit width of the FP 16BF 16, a data amount of the general matrix multiplication computation is reduced to half, thereby reducing power consumption of a neural network chip.

However, because a data precision loss is caused during data format conversion in which high-precision floating-point data is converted into the foregoing two low-precision floating-point data formats for the general matrix multiplication computation, and then the data is converted into a high-precision data format for the non-general matrix multiplication computation, for example, the data is converted into an FP16/BF16 data format, training precision of a neural network is reduced. To reduce the data precision loss, a scaling (scaling) operation is introduced into a training process. However, after the scaling operation, distribution statistics need to be collected on data generated by a tensor core (tensor core), increasing the power consumption of the neural network chip. In addition, the two types of low-precision floating-point data have different performance in precision and dynamic range. User need to select one data format from the two types of low-precision floating-point data for neural network training. Currently, the method cannot indicate the users for selection, resulting in poor user experience and generalization.

In another neural network training method, a block floating-point (block floating-point) is defined for representation of low-precision data, and mixed precision is used during neural network training, thereby reducing power consumption of a neural network chip. Specifically, during general matrix multiplication computation, computation is performed after the data is converted into data in a block floating-point data format, and during non-general matrix multiplication computation, computation is performed after data is converted into data in an FP32 or FP16 data format. During conversion of the data into a block floating-point data format, the high-precision data is first divided into a plurality of blocks (blocks), data distribution in each block is then counted, and data in the block is finally split into a common exponent (exponent) field, and a sign (sign) field and a mantissa (mantissa) field of each piece of data based on the data distribution. In this case, because data in each block has a common exponent, a total bit width of each piece of data in the block is reduced, so that using the data in the block floating-point data format for training can reduce power consumption of the neural network chip.

However, when the data in the block floating-point data format is used for training, because the block floating-point data format limits a representation range of the data, a precision loss of the data is caused, thereby reducing training precision of the neural network. In addition, different computation layers of the neural network have different block division manners, leading to a more complex algorithm procedure. Moreover, a quantization (quant) operation needs to be introduced before the general matrix multiplication computation, and a dequantization (dequant) operation needs to be introduced after the general matrix multiplication computation, and statistics need to be collected on data analysis. This affects performance of neural network training.

Therefore, embodiments of this application provide a floating-point data precision conversion method. The method relates to data format conversion between first floating-point data and second floating-point data. Precision of the first floating-point data is higher than precision of the second floating-point data. In the method, a hybrid rounding manner is used. To be specific, when a coded value of a first exponent field is greater than or equal to a first preset threshold, a stochastic rounding manner is used; or when the coded value of the first exponent field is less than the first preset threshold, a manner of rounding half away from zero is used. Different rounding manners are provided, so that a conversion error during data format conversion can be reduced, data conversion efficiency can be improved, and training precision of model training can be improved.

The method may be applied to the AI field. The floating-point data precision conversion method may be applied to chips such as a central processing unit (central processing unit, CPU), a graphics processing unit (graphics processing unit, GPU), a tensor processing unit (tensor processing unit, TPU), and a neural network processing unit (neural network processing unit, NPU).

Specifically, the second floating-point data provided in embodiments of this application may be HiFloat8 data. As shown in Table 1, Table 1 shows a coding scheme of the HiFloat8 data.

**Table 1 Coding scheme of HiFloat8 data**

| HiFloat8 data | Sign field (S) | Prefix code field (D): {value} | Exponent field (E) | Mantissa field (M) |
|---|---|---|---|---|
| Bit width (width) | 1 | 2:{2, 3, 4} | D | 8-3-D |
| | 1 | 3:{0, 1} | D | 8-4-D |

8 is a total bit width of the HiFloat8 data, and a bit width of the mantissa field may be changed. The sign field occupies one bit. 0 represents a positive number, and 1 represents a negative number; or 1 represents a negative number, and 0 represents a positive number. The prefix code field occupies two or three bits, the prefix code field may represent five different pieces of information, and a value (value) of D may be 0, 1, 2, 3, or 4. A bit width of the exponent field changes with the value of D, and the mantissa field occupies a remaining bit width. For the prefix code field, integer (integer) coding may be used, and in this case, D is a fixed value. For the prefix code field, prefix code (prefix code) coding may alternatively be used, and in this case, D is a finite value set. In the prefix code coding, two bits are used to code values 2, 3, and 4, and three bits are used to code values 0 and 1. A coding scheme of the prefix code field is shown in Table 2. Table 2 shows a coding scheme of the prefix code field.

**Table 2 Coding scheme of a prefix code field**

| Value | Code | Bit width |
|---|---|---|
| 4 | 11 | 2 |
| 3 | 10 | |
| 2 | 01 | |
| 1 | 001 | 3 |
| 0 | 000 | |

It may be learned from Table 2 that, when the point bit field is 2 bits, the value "4" may be coded by using "11", the value "3" may be coded by using "10", and the value "2" may be coded by using "01". When the point bit field is three bits, the value "1" may be coded by using "001", and the value "0" may be coded by using "000". The coding scheme shown in Table 2 is merely an example for description, and constitutes no limitation on this embodiment of this application.

Further, a formula of conversion between HiFloat8 data and a decimal value (X) provided in this embodiment of this application is: X=(-1)^{S}*2^{Eᵢ+E_{c}}*(1+M).

E_{c} is an exponential symmetric center, and is also a bias (bias) in FP32 data.

When D is 0, it represents that a value of the exponent field is 0. When D is not 0, signed magnitude (signed magnitude) value coding is used for the exponent field. To be specific, a sign bit is tailed with a true form (true form, TF), and a code of the exponent field is Eᵢ={Se, l'1b, TF[2:end]}, where Se is a sign bit of the exponent field. If the most significant bit 1'bl of TF is hidden and not stored, the coded value of the exponent field is Eₛ={Se, TF[2:end]}. A coded value of the exponent field in decimal is Eᵥ=Eᵢ+E_{c}.

HiFloat(N, 5, E_{c}) may be configured to be HiFloat(8, 5, 0), HiF8 for short, or there may be other configurations. Distribution of HiFloat8 coded values is shown in Table 3.

**Table 3 HiFloat8 coded value distribution table**

| D | 0 | 1 | 2 | 3 | 4 |
|---|---|---|---|---|---|
| Eₛ | None | Se | Se, TF[2] | Se, TF[2:3] | Se, TF[2:4] |
| Eᵢ | 0 | Se, 1 | Se, 1, TF[2] | Se, 1, TF[2:3] | Se, 1, TF[2:4] |
| Eᵥ | 0 | +l | ±[2, 3] | +[4, 7] | ±[8, 15] |
| M bit width | 4 | 3 | 3 | 2 | 1 |

With reference to Table 1 and Table 2, as shown in Table 3, when D=0, the bit width of the mantissa field is 8-4-0=4. When D=1, the bit width of the mantissa field=8-4-1=3. When D=2, the bit width of the mantissa field=8-3-2=3. When D=3, the bit width of the mantissa field=8-3-3=2. When D=4, the bit width of the mantissa field=8-3-4=1. It may be understood that when the bit width of the exponent field is smaller (that is, a value range is smaller), the bit width occupied by the mantissa field is larger, and value precision is higher. When the bit width of the exponent field is larger (that is, the value range is larger), the bit width occupied by the mantissa field is smaller, and the value precision is lower.

In addition, FIG. 2 is a diagram of distribution of exponent field-mantissa field bit width according to an embodiment of this application. It may be learned from FIG. 2 that a smaller absolute value of the exponent field indicates a larger bit width of the mantissa field. Therefore, the second floating-point data may also be referred to as taper-shaped low-precision floating-point data. In addition, the taper-shaped low-precision floating-point data may also consider both a dynamic range of the data and data precision, so that a conversion error during conversion from high-precision data to a low-precision data format can be reduced, and training precision can be improved.

In some possible implementations, in addition to the foregoing normalized representation, the value X represented by the floating-point number may be selected to represent various special values by user-defined setting.

For example, when S=0, D=4, Eₛ-4'b11ll-15, and M=1'b0, X=0 (zero); when S=1, D=4, Eₛ=4'b11l1=-15, and M=1'b0, X may represent a non-numeric value (not a number, NaN); and when D=4, Eₛ=4'b01l1=15, and M=1'bl, X=positive or negative infinity (±infinity).

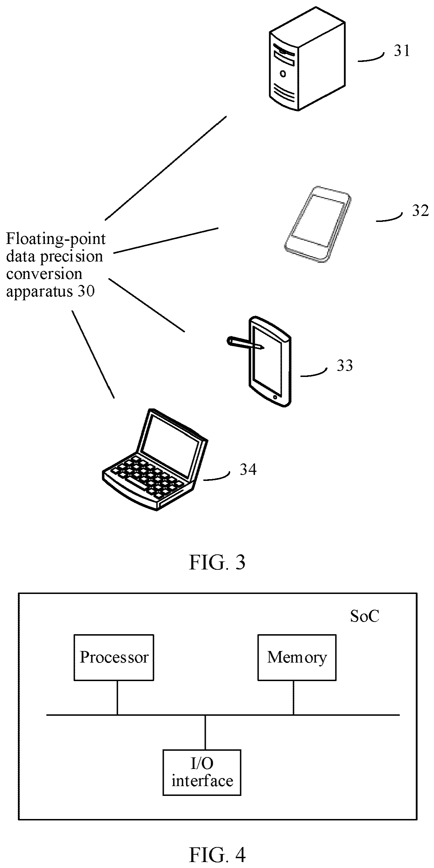

In the foregoing scenario, the floating-point data precision conversion method and apparatus in this application may be used in different systems or devices, for example, used in a floating-point data precision conversion apparatus 30 shown in FIG. 3. FIG. 3 is a diagram of a system or device in which a floating-point data precision conversion apparatus is used according to an embodiment of this application. The floating-point data precision conversion apparatus may be a terminal, for example, a server 3l a mobile phone terminal 32, a tablet computer 33, a notebook computer 34, an augmented reality (augmented reality, AR) device (not shown in FIG. 3), a virtual reality (virtual reality, VR) device (not shown in FIG. 3), or an in-vehicle terminal (not shown in FIG. 3). The floating-point data precision conversion method provided in this application may be applied to a scenario related to mixed precision computation, such as a CPU, high-performance computing (high performance computing, HPC), and AI, in the floating-point data precision conversion apparatus 30, for example, a scalar computation unit, a vector computation unit, a matrix computation unit, and a tensor computation unit.

In some embodiments, the floating-point data precision conversion apparatus provided in this application may be a chip. For example, the chip is a system-on-chip (system-on-chip, SoC). FIG. 4 is a diagram of a structure of a SoC according to an embodiment of this application. The SoC includes a processor. The processor may be a single-core processor or a multi-core processor, a memory, an input/output (input/output, I/O) interface, or the like. After loading data and an application program in the memory, the processor may process the data, for example, perform computation processing in this application. For example, when the data is FP32 data, a coded value of a second mantissa field in second floating-point data may be determined by reading a coded value of a first exponent field in the FP32 data.

The method is applied to the foregoing system or device. The following describes a procedure of a floating-point data precision conversion method provided in embodiments of this application.

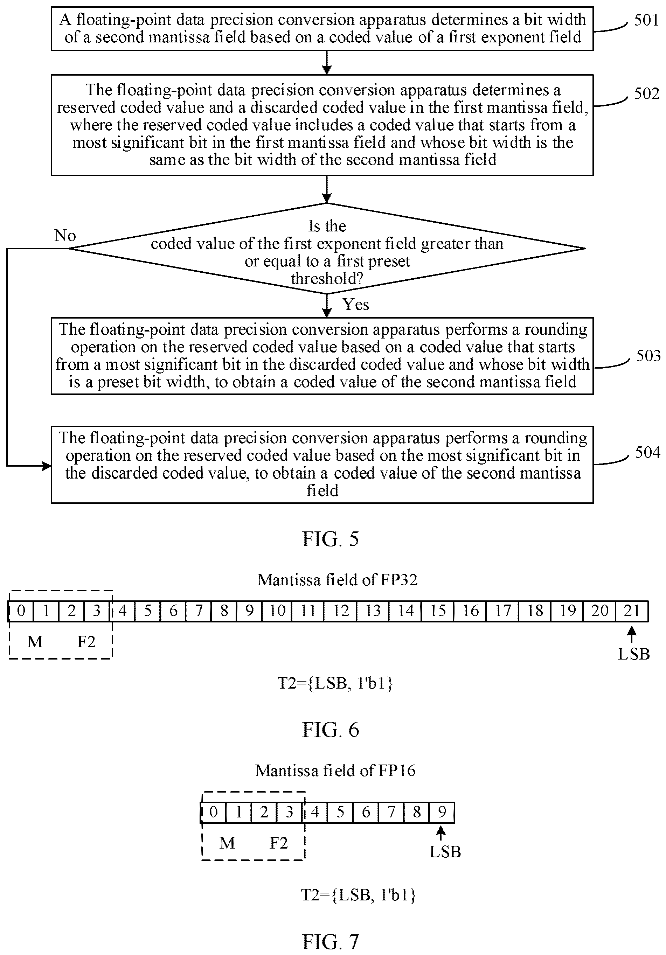

An embodiment of this application provides a floating-point data precision conversion method. FIG. 5 is a flowchart of a floating-point data precision conversion method according to an embodiment of this application. The method is applied to converting first floating-point data into second floating-point data. The first floating-point data may include a first exponent field and a first mantissa field, and the second floating-point data may include a second mantissa field. The method includes the following procedure.

Step 501: A floating-point data precision conversion apparatus determines a bit width of the second mantissa field based on a coded value of the first exponent field.

For example, precision of the first floating-point data is higher than precision of the second floating-point data, where the first floating-point data may be FP32 data or FP16 data, and the second floating-point data may be HiFloat8 data.

During conversion, a bit width of a mantissa field of the HiFloat8 data is variable. In other words, the bit width of the second mantissa field is variable, and the bit width ranges from 1 to 4. It may be understood that a larger bit width of the mantissa field indicates higher precision of the HiFloat8 data.

For example, the first floating-point data is FP32 data. If the coded value of the first exponent field is 8'b01111100, representing 124 in decimal, and a bias in the FP32 data (where for the FP32 data, the bias is 127) is removed, the first exponent field of the FP32 data is the -3^{rd} power of 2. With reference to Table 2 and Table 3, it can be learned that the bit width of the second mantissa field is 2.

Step 502: The floating-point data precision conversion apparatus determines a reserved coded value and a discarded coded value in the first mantissa field, where the reserved coded value includes a coded value that starts from a most significant bit in the first mantissa field and whose bit width is the same as the bit width of the second mantissa field.

For example, the precision of the first floating-point data is higher than the precision of the second floating-point data, and a bit width of a first mantissa field of the first floating-point data is greater than the bit width of the second mantissa field of the second floating-point data. Therefore, if the first floating-point data is converted into the second floating-point data, because the bit width of the second mantissa field of the second floating-point data is limited, rounding needs to be performed on a coded value in the first mantissa field. The coded value that starts from the most significant bit and whose bit width is the same as the bit width of the second mantissa field in the first mantissa field is determined as the reserved coded value, and the remaining coded value other than the reserved coded value in the first mantissa field is determined as the discarded coded value.

An example in which the first floating-point data is FP32 is still used. If the coded value of the first mantissa field is 23'b01000000000000000000000, because the bit width of the second mantissa field is 2, the reserved coded value is 2'b01.

Step 503: If the coded value of the first exponent field is greater than or equal to a first preset threshold, the floating-point data precision conversion apparatus performs a rounding operation on the reserved coded value based on a coded value that starts from a most significant bit and whose bit width is a preset bit width in the discarded coded value, to obtain a coded value of the second mantissa field.

For example, a manner of performing the rounding operation on the reserved coded value based on the coded value that starts from the most significant bit and whose bit width is the preset bit width in the discarded coded value may be understood as a stochastic rounding (stochastic rounding, SR) manner. The preset bit width may be an integer from 1 to 14. A random number is introduced into the SR rounding manner, and a rounding operation is performed on the reserved coded value based on a comparison result between the random number and the coded value that starts from the most significant bit and whose bit width is the preset bit width in the discarded coded value. It may be understood that, the random number in the SR rounding manner is related to the discarded coded value, no additional random number generator is required, and there is no performance bottleneck of random number generation. Therefore, the SR rounding manner not only improves efficiency of converting high-precision data into low-precision data, but also reduces hardware overheads.

Step 504: If the coded value of the first exponent field is less than the first preset threshold, the floating-point data precision conversion apparatus performs a rounding operation on the reserved coded value based on the most significant bit of the discarded coded value, to obtain the coded value of the second mantissa field.

For example, a manner of performing the rounding operation on the reserved coded value based on the most significant bit of the discarded coded value may be understood as a manner of rounding half away from zero (round half away from zero, TA). In the TA rounding manner, the most significant bit of the discarded coded value may be compared with the preset threshold, and the rounding operation is performed on the reserved coded value based on the comparison result. In comparison with other rounding manners, in the TA rounding manner, a hardware implementation area is smaller, power consumption overheads are less, and a data resolution is higher.

Therefore, the SR rounding manner and the TA rounding manner may be understood as a hybrid rounding (hybrid rounding, HR) manner. In the hybrid rounding manner, the SR rounding manner is used for data on two sides that is in a small proportion of Gaussian-like distribution, that is, main data that affects an average value. For intermediate data in a large proportion, the TA rounding manner is used. The hybrid rounding manner may be applied to both the FP32 data and the FP16 data. In comparison with the TA rounding manner or the SR rounding manner, in the hybrid rounding manner, better mean invariance is provided, and hardware overheads are less.

Optionally, the rounding operation includes a carrying operation and a discarding operation, and step 503 may include: When the coded value that starts from the most significant bit and whose bit width is the preset bit width in the discarded coded value is greater than or equal to a second preset threshold, the floating-point data precision conversion apparatus performs a carrying operation on a least significant bit of the reserved coded value, and performs a discarding operation on the discarded coded value, where a coded value obtained through the carrying operation performed on the reserved coded value is the coded value of the second mantissa field. When the coded value that starts from the most significant bit and whose bit width is the preset bit width in the discarded coded value is less than the second preset threshold, a discarding operation is performed on the discarded coded value, where the reserved coded value is the coded value of the second mantissa field. The second preset threshold is a coded value that starts from a least significant bit and whose bit width is the preset bit width in the discarded coded value.

For example, for the SR rounding manner, the preset bit width may be an integer from 1 to 14. An example in which the preset bit width is 14 bits is used. The second preset threshold may be a coded value that starts from a least significant bit and whose bit width is 14 in the discarded coded value. In this case, a part of the discarded coded value that is used to be compared with the second preset threshold is a coded value that starts from the most significant bit and whose bit width is 14 in the discarded coded value. An example in which the coded value of the first mantissa field is 23'b0l000000000000000000000 is still used. In this case, the bit width of the second mantissa field is 2. In this case, the reserved coded value in the first mantissa field is 2'b0l, the discarded coded value is 21'b000000000000000000000, the part of the discarded coded value is 14'b00000000000000, and the second preset threshold is 14'b00000000000000. Because the part of the discarded coded value is equal to the second preset threshold, a discarding operation is performed on the discarded coded value, and the coded value obtained through carrying of the reserved coded value is the coded value of the second mantissa field, that is, the coded value of the second mantissa field is 2'b01.

In an example, FIG. 6 is a diagram of a mantissa field of FP32 data converted into HiFloat8 data in an SR rounding manner according to an embodiment of this application. A least significant bit (least significant bit, LSB) in the mantissa field of the FP32 data is selected to form a 2-bit second preset threshold T2={LSB, l'b1}. First four bits in the discarded coded value may be selected to form F2, that is, F2 is the reserved coded value, and M is the reserved coded value after the rounding operation.

In another example, FIG. 7 is a diagram of a mantissa field of FP16 data converted into HiFloat8 data in an SR rounding manner according to an embodiment of this application. A least significant bit (least significant bit, LSB) in the mantissa field of the FP16 data is selected to form a 2-bit second preset threshold T2={LSB, l'b1}. First four bits in the discarded coded value may be selected to form F2.

Applicable to the mantissa field in FIG. 6 and FIG. 7, SR rounding is defined as: if F2≥T2, M+1, else M. In other words, if F2 is greater than or equal to T2, a carrying operation is performed on the reserved coded value. If F2 is less than T2, a discarding operation is performed on the discarded coded value.

In another implementation, any bit width in the first mantissa field of the first floating-point data is used as the second preset threshold in a manner of {*aₙ*, 1} or {negate(*a*ₙ), 1}, where a negate operation represents a meaning of negation of 0 and 1, negate(0)=1, and negate(1)=0. The part of the discarded coded value in the first mantissa field is compared with the second preset threshold, to obtain an SR rounding result. In an example, the preset bit width is one bit. If the most significant bit of the discarded coded value is 0, {1'b0, 1'b1}=0.25, and a discarding operation is performed on the discarded coded value. If the most significant bit of the discarded coded value is 1, {1'bl, l'b1}=0.75, and a carrying operation is performed on the least significant bit of the reserved coded value.

An error of single data in the SR rounding manner is 0.75 unit in the last place (unit in the last place, ulp), and the error is less than 1 ulp of standard stochastic rounding. In addition, if data is evenly distributed, mean invariance of the SR rounding manner is better than mean invariance of the standard stochastic rounding.

Optionally, the rounding operation includes a carrying operation and a discarding operation, and step 504 may include: When the most significant bit of the discarded coded value is greater than or equal to a third preset threshold, the floating-point data precision conversion apparatus performs a carrying operation on the least significant bit of the reserved coded value, and performs a discarding operation on the discarded coded value, where a coded value obtained through carrying of the reserved coded value is the coded value of the second mantissa field. When the most significant bit of the discarded coded value is less than the third preset threshold, a discarding operation is performed on the discarded coded value, and the reserved coded value is the coded value of the second mantissa field.

For example, for the TA rounding manner, the third preset threshold may be 1. In an example, when the most significant bit of the discarded coded value is 1, a carrying operation is performed on the least significant bit of the reserved coded value, and a discarding operation is performed on the discarded coded value. In another example, when the most significant bit of the discarded coded value is 0, a discarding operation is performed on the discarded coded value.

For the TA rounding manner, the third preset threshold may alternatively be 0. When the most significant bit of the discarded coded value is greater than 0, a carrying operation is performed on the least significant bit of the reserved coded value, and a discarding operation is performed on the discarded coded value. The coded value obtained by performing the carrying operation on the reserved coded value is the coded value of the second mantissa field. When the most significant bit of the discarded coded value is less than or equal to 0, a discarding operation is performed on the discarded coded value, and the reserved coded value is a first coded value of the second mantissa field.

Optionally, the first preset threshold is determined by traversing a plurality of pieces of first floating-point data.

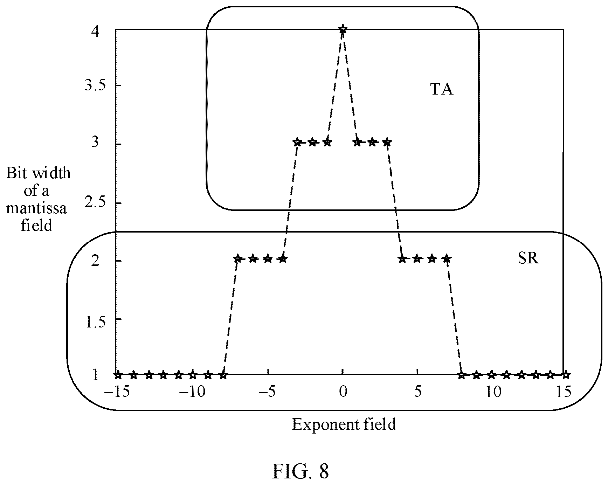

For example, the plurality of pieces of first floating-point data are traversed, that is, coded values of different first exponent fields are traversed, so that it can be determined that when the first preset threshold is 4, a minimum conversion error may be obtained. FIG. 8 is a diagram of distribution of a hybrid rounding manner according to an embodiment of this application. An exponent value of HiFloat8 is E=[-15, 15], where abs(E)=[0, 15]. If E≥4, the TA rounding manner is used. If E<4, the SR rounding manner is used.

Optionally, the first floating-point data further includes a sign field, the second floating-point data further includes the sign field, a prefix code field, and a second exponent field. The prefix code field indicates a bit width of the second exponent field. The method further includes: determining a bit width of the prefix code field, a coded value of the prefix code field, a bit width of the second exponent field, and a coded value of the second exponent field based on the coded value of the first exponent field. For example, in data format conversion, positive and negative values of data remain unchanged. To be specific, bit widths and coded values of sign fields of the first floating-point data and the second floating-point data are the same.

For the prefix code field and the second exponent field, an exponent value N of the first exponent field may be determined based on the coded value of the first exponent field. Refer to Table 1. The value of D may be determined based on the exponent value of the first exponent field. In an example, the first floating-point data is FP32 data. It is assumed that the coded value of the first exponent field is 8'b01111100, representing 124 in decimal. After a bias 127 for the FP32 data is removed, -3 in decimal is obtained. -3 is the exponent value N of the first exponent field, and by using a formula D=INT[log2|N|], it may be obtained that D is 2. By viewing Table 2, it may be determined that a bit width of a prefix code field corresponding to 2 is 2, a first coded value of the prefix code field is 01, and a bit width of the second exponent field is 2. Still viewing Table 3, when D is 2, and the exponent value of the first exponent field is -3, that is, the exponent sign bit Se is 1, because the bit width of the second exponent field is 2, a determined coded value of the second exponent field is 2'b11.

It may be understood that, if a carrying operation is performed on the reserved coded value, the reserved coded value may overflow. An execution device needs to first determine whether the reserved coded value obtained through the carrying operation overflows, and if the reserved coded value obtained through the carrying operation overflows, 1 is added to the least significant bit of the coded value of the first exponent field, to obtain a new coded value of the first exponent field. The execution device then determines a new bit width of the second exponent field and a new bit width of the prefix code field based on the new coded value of the first exponent field. If the new bit width of the prefix code field is different from an original bit width of the prefix code field, a new coded value of the prefix code field, a new coded value of the second exponent field, a new bit width of the second mantissa field, and a new coded value of the second mantissa field are determined based on the new coded value of the first exponent field. If the new bit width of the prefix code field is the same as the original bit width of the prefix code field, whether the new bit width of the second exponent field is the same as an original bit width of the second exponent field is determined. If the new bit width of the second exponent field is less than the original bit width of the second exponent field, 1 is added to the bit width of the reserved coded value, to obtain the new bit width of the second mantissa field and the new coded value of the second mantissa field. If the new bit width of the second exponent field is greater than the original bit width of the second exponent field, a discarding operation is performed on the least significant bit of the reserved coded value, to obtain the new bit width of the second mantissa field and the new coded value of the second mantissa field.

The floating-point data precision conversion method provided in embodiments of this application may be applied to a neural network training procedure. The neural network training procedure includes model weight parameter initialization, forward computation, backward computation, a weight update procedure, and a multi-machine multi-card data communication procedure.

In a model weight parameter initialization procedure, the weight uses the high-precision floating-point data format. Different initialization solutions are used for different application scenarios. For a training process and a pretraining process that start from zero, high-precision floating-point data is used for random initialization. A randomization manner is consistent with an FP16 mixed precision manner or an FP32 precision manner. For a retraining process based on FP32 or FP16 mixed precision weight, weight data obtained in an FP32 or FP16 mixed precision training process is directly loaded. An initialization manner of other parameters in a model, such as a normalization layer parameter and an optimizer parameter, is consistent with an initialization manner of a weight during training and retraining.

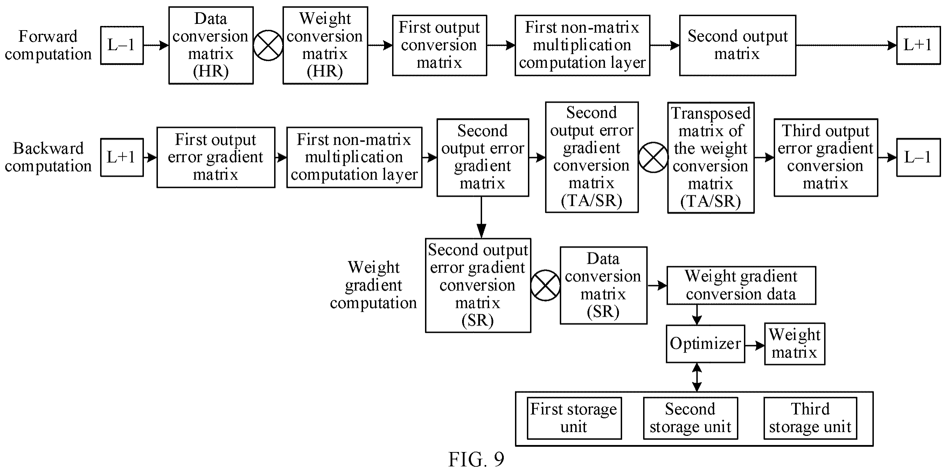

After a weight parameter is initialized, FIG. 9 is a flowchart of neural network training according to an embodiment of this application. L-l represents a training process corresponding to a previous matrix multiplication computation layer of a first matrix multiplication computation layer, L+1 represents a training process corresponding to a next matrix multiplication computation layer of the first matrix computation layer, and training processes of L-l and L+1 are the same as training processes of a data matrix and a weight matrix corresponding to the first matrix multiplication computation layer.

In a forward computation procedure, for GEMM operations at the first and intermediate layers of the network, the FP32 or the FP16 data needs to be converted into a taper-shaped low-precision floating-point data format, and input to a GEMM computation unit, and the FP32 or the FP16 data is output. For an activation layer and a normalization layer, the FP32 or the FP16 data is used for computation. For a tail layer of the neural network, an FP32 data type or an FP16 data type is uniformly maintained. A specific procedure is: Based on a data conversion matrix and a weight conversion matrix of the first floating-point data format, forward computation is performed on a matrix multiplication computation layer, to obtain a first output conversion matrix of the second floating-point data format. A first non-matrix multiplication computation layer is obtained through forward computation performed on the first output conversion matrix, and a second output matrix in the first floating-point data format is obtained. The second output matrix is used as an input matrix of a next computation layer of the first non-matrix multiplication computation layer when forward computation is performed.

In a backward computation procedure, a backward procedure of the taper-shaped low-precision floating-point mixed precision is consistent with a backward procedure of FP16 training. An automatic scaling operation is performed. That is, a loss (loss) is multiplied by a proper scaling value, and then backward differentiation is performed. In a differentiation process of a feature map (feature map) and a weight, an input of GEMM is taper-shaped low-precision floating-point data. A specific procedure is: A first output error gradient matrix in a second floating-point data format is obtained, where the first output error gradient matrix is used to update a parameter corresponding to the first non-matrix multiplication computation layer. The first non-matrix multiplication computation layer is backward propagated based on the first output error gradient matrix, to obtain a second output error gradient matrix in the first floating-point data format. The second output error gradient matrix is converted into a second output error gradient conversion matrix in the second floating-point data format, and the first matrix multiplication computation layer is backward propagated based on a second output error gradient conversion matrix and a transposed matrix of a weight conversion matrix, to obtain a third output error gradient conversion matrix in the first floating-point data format. The third output error gradient conversion matrix is used to update a parameter corresponding to a previous computation layer of the first matrix multiplication computation layer during forward computation of the neural network.

A weight gradient computation procedure may be: inputting the second output error gradient conversion matrix and the data conversion matrix into the first matrix multiplication computation layer, to obtain weight gradient conversion data in a third data format, and updating the weight matrix based on weight gradient conversion data.

In a possible embodiment, as shown in FIG. 9, the weight matrix and other parameters may be converted into data in a high-precision data format, and the data is backed up and stored in a local storage device. For example, the weight matrix in the high-precision data format may be stored in a first storage unit w-master, a state parameter of an optimizer may be stored in a second storage unit momentum, and other parameters may be stored in a third storage unit other states.

In addition, large-scale model training is usually performed in a multi-machine manner, and involves data parallelism, model parallelism, pipeline parallelism, and a combination of the three parallel manners. A multi-machine multi-card training manner requires inter-card data communication, and the communication via the taper-shaped low-precision floating-point data can effectively resolve a transmission bandwidth problem.

The first floating-point data may be converted into the second floating-point data in different rounding manners in the forward computation and backward computation. This is not limited in embodiments of this application.

Example 1: As shown in FIG. 9, a hybrid rounding manner may be used for the forward computation, and a TA/an SR manner may be used for the backward computation.

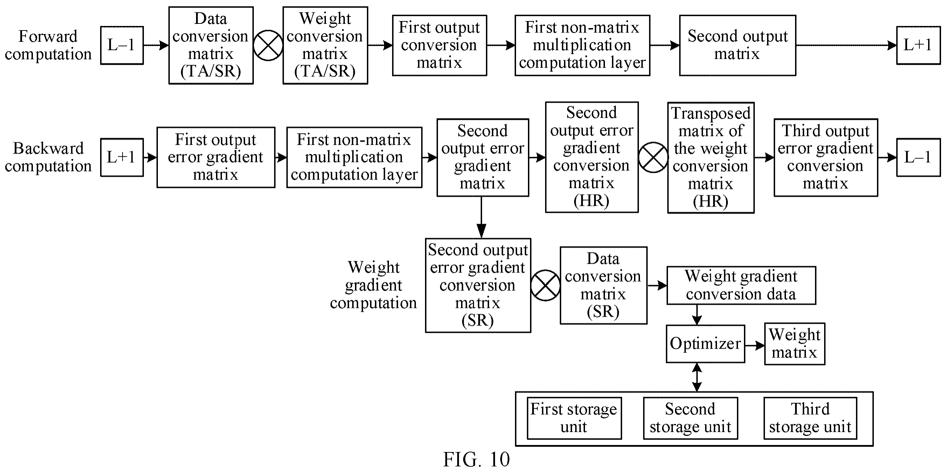

Example 2: FIG. 10 is another flowchart of neural network training according to an embodiment of this application. The TA/SR manner may be used for the forward computation, and the hybrid rounding manner may be used for the backward computation.

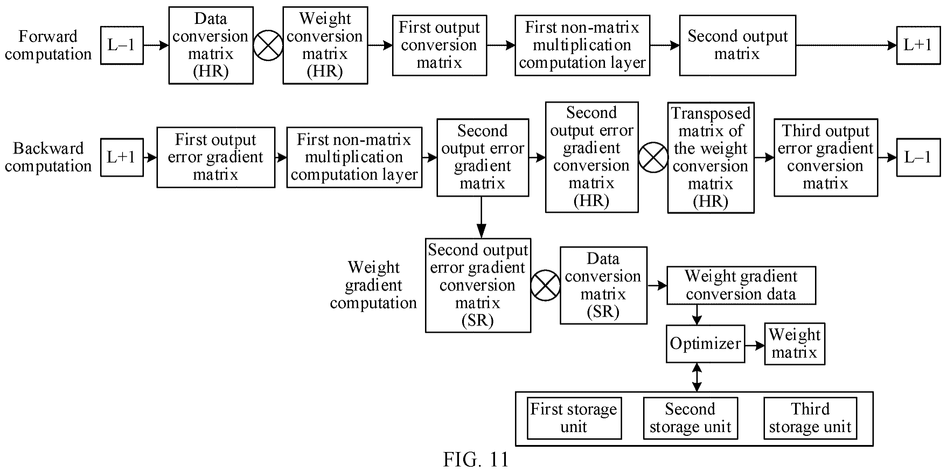

Example 3: FIG. 11 is another flowchart of neural network training according to an embodiment of this application. The hybrid rounding manner may be used for the forward computation, and the hybrid rounding manner may also be used for the backward computation.

Therefore, according to the floating-point data precision conversion method provided in embodiments of this application, in an artificial intelligence network model like a convolutional neural network or a transformer model, training precision consistent with mixed precision of FP32 or FP16 can be implemented. In a bilateral mode (where the hybrid rounding manner is used for both the forward computation and the backward computation), average accuracy is higher than accuracy in a unilateral mode (where the hybrid rounding manner is used for the forward computation or the backward computation).

It may be understood that, to implement the foregoing functions, an electronic device includes a corresponding hardware and/or software module for performing each function. With reference to algorithm steps of examples described in embodiments disclosed in this specification, this application can be implemented in a form of hardware or a combination of hardware and computer software. Whether a function is performed by hardware or hardware driven by computer software depends on particular applications and design constraints of the technical solutions. A person skilled in the art may use different methods to implement the described functions for each particular application with reference to embodiments, but it should not be considered that the implementation goes beyond the scope of this application.

In embodiments, the electronic device may be divided into functional modules based on the foregoing method examples, for example, each functional module may be obtained through division based on each corresponding function, or two or more functions may be integrated into one processing module. The integrated module may be implemented in a form of hardware. It should be noted that module division in embodiments is an example and is merely logical function division. In actual implementation, there may be another division manner.

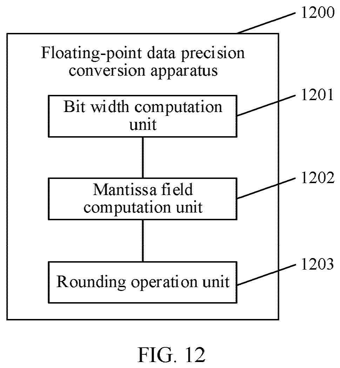

When each functional module is obtained through division based on each corresponding function, FIG. 12 is a possible diagram of composition of a floating-point data precision conversion apparatus 1200 in the foregoing embodiments. As shown in FIG. 12, the floating-point data precision conversion apparatus 1200 may include: a bit width computation unit 1201, a mantissa field computation unit 1202, and a rounding operation unit 1203.

The bit width computation unit 1201 may be configured to support the floating-point data precision conversion apparatus 1200 in performing step 501 and the like, and/or used in another process of the technology described in this specification.

The mantissa field computation unit 1202 may be configured to support the floating-point data precision conversion apparatus 1200 in performing step 502 and the like, and/or used in another process of the technology described in this specification.

The rounding operation unit 1203 may be configured to support the floating-point data precision conversion apparatus 1200 in performing step 503, step 504, and the like, and/or used in another process of the technology described in this specification.

It should be noted that all related content of the steps in the foregoing method embodiments may be cited in function descriptions of corresponding functional modules. Details are not described herein again.

The floating-point data precision conversion apparatus 1200 provided in this embodiment is configured to perform the foregoing floating-point data precision conversion method, and therefore can achieve the same effect as the foregoing implementation method.

When an integrated unit is used, the floating-point data precision conversion apparatus 1200 may include a processing module, a storage module, and a communication module. The processing module may be configured to control and manage an action of the floating-point data precision conversion apparatus 1200, for example, may be configured to support the floating-point data precision conversion apparatus 1200 in performing the steps performed by the bit width computation unit 1201, the mantissa field computation unit 1202, and the rounding operation unit 1203. The storage module may be configured to support the floating-point data precision conversion apparatus 1200 in storing program code, data, and the like. The communication module may be configured to support the floating-point data precision conversion apparatus 1200 in communicating with another device, for example, communicating with a wireless access device.

The processing module may be a processor or a controller. The processor may implement or execute various example logical blocks, modules, and circuits described with reference to content disclosed in this application. The processor may alternatively be a combination for implementing a computing function, for example, a combination including one or more microprocessors or a combination of a digital signal processor (digital signal processor, DSP) and a microprocessor. The storage module may be a memory. The communication module may be specifically a device, such as a radio frequency circuit, a Bluetooth chip, or a Wi-Fi chip, that interacts with another electronic device.

An embodiment of this application further provides an electronic device, including one or more processors and one or more memories. The one or more memories are coupled to the one or more processors. The one or more memories are configured to store computer program code, and the computer program code includes computer instructions. When the one or more processors execute the computer instructions, the electronic device is enabled to perform the foregoing related method steps, to implement the floating-point data precision conversion method in the foregoing embodiments.

An embodiment of this application further provides a computer storage medium. The computer storage medium stores computer instructions. When the computer instructions are run on an electronic device, the electronic device is enabled to perform the related method steps, to implement the floating-point data precision conversion method in the foregoing embodiments.

An embodiment of this application further provides a computer program product. When the computer program product is run on a computer, the computer is enabled to perform the foregoing related steps, to implement the floating-point data precision conversion method performed by the electronic device in the foregoing embodiments.

In addition, an embodiment of this application further provides an apparatus. The apparatus may be specifically a chip, a component, or a module. The apparatus may include a processor and a memory that are connected. The memory is configured to store computer-executable instructions, and when the apparatus runs, the processor may execute the computer-executable instructions stored in the memory, to enable the chip to perform the floating-point data precision conversion method performed by the electronic device in the foregoing method embodiments.

The electronic device, the computer storage medium, the computer program product, or the chip provided in embodiments is configured to perform the corresponding method provided above. Therefore, for beneficial effects that can be achieved by the electronic device, the computer storage medium, the computer program product, or the chip, refer to the beneficial effects in the corresponding method provided above. Details are not described herein.

Based on the descriptions of the foregoing implementations, a person skilled in the art may understand that, for a purpose of convenient and brief description, division into the foregoing functional modules is merely used as an example for illustration. In actual application, the foregoing functions may be allocated to different functional modules and implemented based on requirements. In other words, an inner structure of an apparatus is divided into different functional modules, to implement all or some of the functions described above.

In the several embodiments provided in this application, it should be understood that the disclosed apparatus and method may be implemented in other manners. For example, the described apparatus embodiment is merely an example. For example, the module or division into the units is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may be one or more physical units, may be located in one place, or may be distributed on different places. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit. The integrated unit may be implemented in a form of hardware, or may be implemented in a form of a software functional unit.

When the integrated unit is implemented in the form of a software functional unit and sold or used as an independent product, the integrated unit may be stored in a readable storage medium. Based on such an understanding, the technical solutions in embodiments of this application essentially, or the part contributing to the related art, or all or some of the technical solutions may be implemented in the form of a software product. The software product is stored in a storage medium and includes several instructions for instructing a device (which may be a single-chip microcomputer, a chip or the like) or a processor (processor) to perform all or some of the steps of the methods described in embodiments of this application. The storage medium includes various media that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art in the technical scope disclosed in this application shall fall within the protection scope of this application. Therefore, the protection scope of this application shall be subject to the protection scope of the claims.

## Claims

1. A floating-point data precision conversion method, wherein first floating-point data comprises a first exponent field and a first mantissa field, second floating-point data comprises a second mantissa field, precision of the first floating-point data is higher than precision of the second floating-point data, and the method comprises:
determining a bit width of the second mantissa field based on a coded value of the first exponent field;
determining a reserved coded value and a discarded coded value in the first mantissa field, wherein the reserved coded value comprises a coded value that starts from a most significant bit in the first mantissa field and whose bit width is the same as the bit width of the second mantissa field; and
if the coded value of the first exponent field is greater than or equal to a first preset threshold, performing a rounding operation on the reserved coded value based on a coded value that starts from a most significant bit and whose bit width is a preset bit width in the discarded coded value, to obtain a coded value of the second mantissa field; or
if the coded value of the first exponent field is less than the first preset threshold, performing a rounding operation on the reserved coded value based on the most significant bit of the discarded coded value, to obtain a coded value of the second mantissa field.

2. The method according to claim 1, wherein the rounding operation comprises a carrying operation and a discarding operation, and the performing a rounding operation on the reserved coded value based on a coded value that starts from a most significant bit and whose bit width is a preset bit width in the discarded coded value, to obtain a coded value of the second mantissa field comprises:
when the coded value that starts from the most significant bit and whose bit width is the preset bit width in the discarded coded value is greater than or equal to a second preset threshold, performing a carrying operation on a least significant bit of the reserved coded value, and performing a discarding operation on the discarded coded value, wherein a coded value obtained through carrying of the reserved coded value is the coded value of the second mantissa field; or
when the coded value that starts from the most significant bit and whose bit width is the preset bit width in the discarded coded value is less than the second preset threshold, performing a discarding operation on the discarded coded value, wherein the reserved coded value is the coded value of the second mantissa field, wherein
the second preset threshold is a coded value that starts from a least significant bit and whose bit width is the preset bit width in the discarded coded value.

3. The method according to claim 1, wherein the rounding operation comprises a carrying operation and a discarding operation, and the performing a rounding operation on the reserved coded value based on the most significant bit of the discarded coded value, to obtain a coded value of the second mantissa field comprises:
when the most significant bit of the discarded coded value is greater than or equal to a third preset threshold, performing a carrying operation on a least significant bit of the reserved coded value, and performing a discarding operation on the discarded coded value, wherein a coded value obtained through carrying of the reserved coded value is the coded value of the second mantissa field; or
when the most significant bit of the discarded coded value is less than the third preset threshold, performing a discarding operation on the discarded coded value, wherein the reserved coded value is the coded value of the second mantissa field.

4. The method according to any one of claims 1 to 3, wherein the first preset threshold is determined by traversing a plurality of pieces of first floating-point data.

5. The method according to claim 1, wherein the first floating-point data further comprises a sign field, the second floating-point data further comprises the sign field, a prefix code field, and a second exponent field, the prefix code field indicates a bit width of the second exponent field, and before the determining a bit width of the second mantissa field based on a coded value of the first exponent field, the method further comprises:
determining a bit width of the prefix code field, a coded value of the prefix code field, the bit width of the second exponent field, and a coded value of the second exponent field based on the coded value of the first exponent field.

6. A floating-point data precision conversion apparatus, wherein first floating-point data comprises a first exponent field and a first mantissa field, second floating-point data comprises a second mantissa field, precision of the first floating-point data is higher than precision of the second floating-point data, and the apparatus comprises:
a bit width computation unit, configured to determine a bit width of the second mantissa field based on a coded value of the first exponent field;
a mantissa field computation unit, configured to determine a reserved coded value and a discarded coded value in the first mantissa field, wherein the reserved coded value comprises a coded value that starts from a most significant bit in the first mantissa field and whose bit width is the same as the bit width of the second mantissa field; and
a rounding operation unit, configured to: if the coded value of the first exponent field is greater than or equal to a first preset threshold, perform a rounding operation on the reserved coded value based on a coded value that starts from a most significant bit and whose bit width is a preset bit width in the discarded coded value, to obtain a coded value of the second mantissa field, wherein
the rounding operation unit is further configured to: if the coded value of the first exponent field is less than the first preset threshold, perform a rounding operation on the reserved coded value based on the most significant bit of the discarded coded value, to obtain the coded value of the second mantissa field.

7. The apparatus according to claim 6, wherein the rounding operation comprises a carrying operation and a discarding operation, and the rounding operation unit is further configured to:
when the coded value that starts from the most significant bit and whose bit width is the preset bit width in the discarded coded value is greater than or equal to a second preset threshold, perform a carrying operation on a least significant bit of the reserved coded value, and perform a discarding operation on the discarded coded value, wherein a coded value obtained through carrying of the reserved coded value is the coded value of the second mantissa field; or
when the coded value that starts from the most significant bit and whose bit width is the preset bit width in the discarded coded value is less than the second preset threshold, perform a discarding operation on the discarded coded value, wherein the reserved coded value is the coded value of the second mantissa field, wherein
the second preset threshold is a coded value that starts from a least significant bit and whose bit width is the preset bit width in the discarded coded value.

8. The apparatus according to claim 6, wherein the rounding operation comprises a carrying operation and a discarding operation, and the rounding operation unit is further configured to:
when the most significant bit of the discarded coded value is greater than or equal to a third preset threshold, perform a carrying operation on a least significant bit of the reserved coded value, and perform a discarding operation on the discarded coded value, wherein a coded value obtained through carrying of the reserved coded value is the coded value of the second mantissa field; or
when the most significant bit of the discarded coded value is less than the third preset threshold, perform a discarding operation on the discarded coded value, wherein the reserved coded value is the coded value of the second mantissa field.

9. The apparatus according to any one of claims 6 to 8, wherein the first preset threshold is determined by traversing a plurality of pieces of first floating-point data.

10. The apparatus according to claim 6, wherein the first floating-point data further comprises a sign field, the second floating-point data further comprises the sign field, a prefix code field, and a second exponent field, the prefix code field indicates a bit width of the second exponent field, and the bit width computation unit is further configured to:
determine a bit width of the prefix code field, a coded value of the prefix code field, the bit width of the second exponent field, and a coded value of the second exponent field based on the coded value of the first exponent field.

11. A floating-point data precision conversion apparatus, comprising a processor and a memory, wherein the memory stores computer instructions, and after executing the computer instructions, the processor performs the method according to any one of claims 1 to 5.

12. A computer-readable storage medium, comprising computer instructions, wherein when the computer instructions are run on an electronic device, the electronic device is enabled to perform the method according to any one of claims 1 to 5.
